Europäisches Patentamt

European Patent Office

Office européen des brevets

(11) Numéro de publication : **0 430 829 A1**

## (12) DEMANDE DE BREVET EUROPEEN

(21) Numéro de dépôt : **90420508.5**

(22) Date de dépôt : **22.11.90**

(51) Int. Cl.$^5$ : **H01L 21/82**

(30) Priorité : **28.11.89 FR 8916008**

(43) Date de publication de la demande :
**05.06.91 Bulletin 91/23**

(84) Etats contractants désignés :
**DE FR GB IT**

(71) Demandeur : **SGS-THOMSON
MICROELECTRONICS S.A.
7, Avenue Galliéni
F-94250 Gentilly (FR)**

(72) Inventeur : **Bergemont, Albert
Cabinet Michel de Beaumont, 1 bis Rue
Champollion
F-38000 Grenoble (FR)**

(74) Mandataire : **de Beaumont, Michel
1bis, rue Champollion
F-38000 Grenoble (FR)**

(54) **Procédé de fabrication de circuits intégrés constituant des mémoires EPROM.**

(57)     La présente invention concerne un procédé de fabrication de transistors MOS à grille flottante de mémoire non volatile, comprenant les étapes consistant à :
- réaliser des zones d'isolement latéral,
- réaliser entre les zones d'isolement latéral des transistors MOS à double grille, les deux grilles (2, 4) étant recouvertes dessus (6) et latéralement (7) d'une couche isolante,
- déposer une couche de siliciure réfractaire,
- graver cette couche de siliciure de façon à n'en conserver que des îlots s'étendant au niveau des contacts de drain (9) et débordant latéralement jusqu'au dessus des grilles (2, 4) et des zones d'isolement latéral,
- déposer une couche d'isolement (17) et y réaliser des ouvertures débouchant au niveau des îlots de siliciure,
- déposer une couche de métal (18) et la graver pour réaliser les connexions nécessaires avec les drains (9).

Figure 7

EP 0 430 829 A1

# PROCEDE DE FABRICATION DE CIRCUITS INTEGRES CONSTITUANT DES MEMOIRES EPROM

La présente invention concerne le domaine de la fabrication des circuits intégrés de type MOS, et plus particulièrement la fabrication des circuits intégrés comprenant des transistors à grille flottante pour mémoire non volatile électriquement programmable, communément appelée mémoire EPROM.

Dans la majeure partie des cas, un point mémoire d'une mémoire EPROM de grande capacité comporte un transistor ayant une grille flottante réalisée par un premier niveau de silicium polycristallin et une grille de commande réalisée par un deuxième niveau de silicium polycristallin. Les sources des transistors sont connectées à un bus à potentiel bas Vss, la ligne de mot pour désigner une ligne de cellules est constituée par le deuxième niveau de silicium polycristallin, et la ligne de bit pour lire l'état d'une cellule est constituée par une ligne de métal, généralement de l'aluminium, croisant les lignes de mot et contactant de place en place le drain des transistors. En général, un seul point de contact est prévu pour deux drains adjacents de deux transistors d'une même colonne, et, de même, on peut prévoir un seul contact entre les sources des deux transistors adjacents et le bus au potentiel Vss. Les transistors sont séparés les uns des autres par de l'oxyde de silicium épais.

Les techniques de fabrication de tels circuits intégrés constituant des mémoires EPROM sont en général du type MOS. L'invention concerne donc plus précisément un procédé de fabrication de mémoire EPROM par une technique de type MOS.

Les transistors seront par exemple des transistors à canal n, formés dans un substrat de silicium de type p⁻.

Chaque transistors possède une région de source de type n⁺ et une région de drain de type n⁺ également, ces deux régions étant séparées par une région de canal de type p⁻ recouverte par une grille flottante. La grille flottante est isolée du canal par une couche isolante mince, en principe un oxyde de silicium, cette grille flottante étant elle-même recouverte d'une grille de commande, ces deux grilles superposées étant isolées entre elles par une autre couche isolante mince.

Les grilles flottantes sont des rectangles de silicium polycristallin obtenus par gravure d'une première couche de silicium polycristallin appelée "premier niveau de silicium polycristallin". Les grilles de commande sont des bandes étroites de silicium polycristallin obtenus par gravure d'une deuxième couche de silicium polycristallin appelée "deuxième niveau de silicium polycristallin". Ces bandes s'étendent dans la direction des rangées horizontales du réseau et elles constituent à la fois les grilles de commande et les lignes de mot qui relient ces grilles.

Après avoir ainsi réalisé les deux grilles superposées et les zones dopées constituant les drains et les sources, on recouvre l'ensemble formé par les deux grilles superposées par une couche isolante, en principe de l'oxyde de silicium. Cette couche recouvre la partie supérieure ainsi que les bords latéraux des grilles. A ce stade de réalisation, il convient de constituer les connexions par une couche de métal, en principe de l'aluminium, en prenant contact sur chaque drain consécutif de façon à constituer la ligne de bit correspondante.

Pour effectuer cette opération, il a été déjà proposé de procéder aux opérations suivantes :
- déposer une couche de nitrure de silicium (Si₃N₄),
- déposer une couche d'isolement et réaliser par gravure de cette couche des ouvertures au niveau des contacts drain à prendre, l'opération de gravure devant être arrêtée dès que l'on débouche sur la couche de nitrure de silicium,
- enlever la couche de nitrure de silicium apparente puis déposer la couche de métal et la graver de façon à obtenir la ligne de bit établissant les connexions avec les zones constituant les drains.

Ce procédé présente certains inconvénients qui vont maintenant être exposés.

La couche isolante est constituée généralement d'un verre fortement dopé au bore et au phosphore, appelé communément BPSG. Il a été constaté qu'il y avait une certaine difficulté à graver ce BPSG et à arrêter la gravure au niveau de la couche sous-jacente de nitrure de silicium parce qu'il existe une trop faible sélectivité de gravure entre le BPSG et le nitrure de silicium. Cette faible sélectivité ne parvient pas à compenser les variations d'épaisseur de la couche de BPSG, ce qui peut amener à des surgravures locales dans l'oxyde situé dessus la grille supérieure.

D'autre part, comme la zone de contact s'étend jusqu'au niveau de l'isolation latérale, généralement obtenue par le procédé LOCOS il existe aussi au niveau de l'oxyde épais constituant le LOCOS une surgravure, en particulier au niveau du bec d'oiseau. Le métal qui sera déposé à cet endroit du bec d'oiseau ainsi aminci ne sera plus situé au-dessus d'une zone correctement implantée n⁺, ce qui pourra provoquer des courts-circuits.

La présente invention vise donc un procédé de réalisation de mémoire de type EPROM dans lequel les inconvénients précédemment cités sont résolus.

L'invention concerne donc tout particulièrement un procédé de fabrication de circuits intégrés de type MOS à transistor à grille flottante pour mémoire non volatile, comprenant les étapes suivantes :
- réaliser des zones d'isolement latéral,
- réaliser entre les zones d'isolement latéral des transistors MOS à double grille, les deux grilles étant recouvertes dessus et latéralement d'une couche isolante.

Selon une caractéristique essentielle de l'invention, le procédé comprend en outre les étapes suivantes :

- déposer une couche de siliciure de métal réfractaire,
- graver cette couche de siliciure de façon à n'en conserver que des îlots s'étendant au niveau des contacts drain ou source et débordant latéralement, d'une part jusqu'au dessus des grilles et d'autre part jusqu'au dessus des zones d'isolement latéral,
- déposer une couche d'isolement et réaliser par gravure de cette couche des ouvertures débouchant au niveau des îlots de siliciure de métal réfractaire,
- puis déposer une couche de métal et réaliser par gravure de cette couche de métal les connexions nécessaires avec les drains ou les sources.

Selon un mode de réalisation de l'invention, ladite couche de siliciure de métal réfractaire est constituée d'une couche de siliciure de tantale (TaSi$_2$) dans laquelle le silicium est légèrement sur-stœchiométrique.

Selon un mode de réalisation de l'invention, la couche de siliciure de métal réfractaire est constituée d'une couche de siliciure de tungstène (WSi$_2$) dans lequel le silicium est légèrement sur-stœchiométrique.

Selon un mode de réalisation de l'invention, la couche isolante est constituée d'un verre de silice dopé au bore et au phosphore.

Ces objets, caractéristiques et avantages ainsi que d'autres de la présente invention seront exposés plus en détail dans la description suivante d'un mode de réalisation particulier faite en relation avec les figures jointes dans lesquelles :

La figure 1 montre schématiquement un transistor de mémoire EPROM fabriqué selon un procédé classique ;

La figure 2 montre une étape intermédiaire de fabrication du transistor de la figure 1 ;

Les figures 3 et 5 montrent des défauts apparaissant lors de cette étape intermédiaire de fabrication selon le procédé classique ;

Les figures 6 et 7 montrent des étapes successives de fabrication d'un transistor de mémoire EPROM selon un procédé conforme à la présente invention.

Les mêmes références sont utilisées dans ces diverses figures pour désigner des éléments identiques ou semblables.

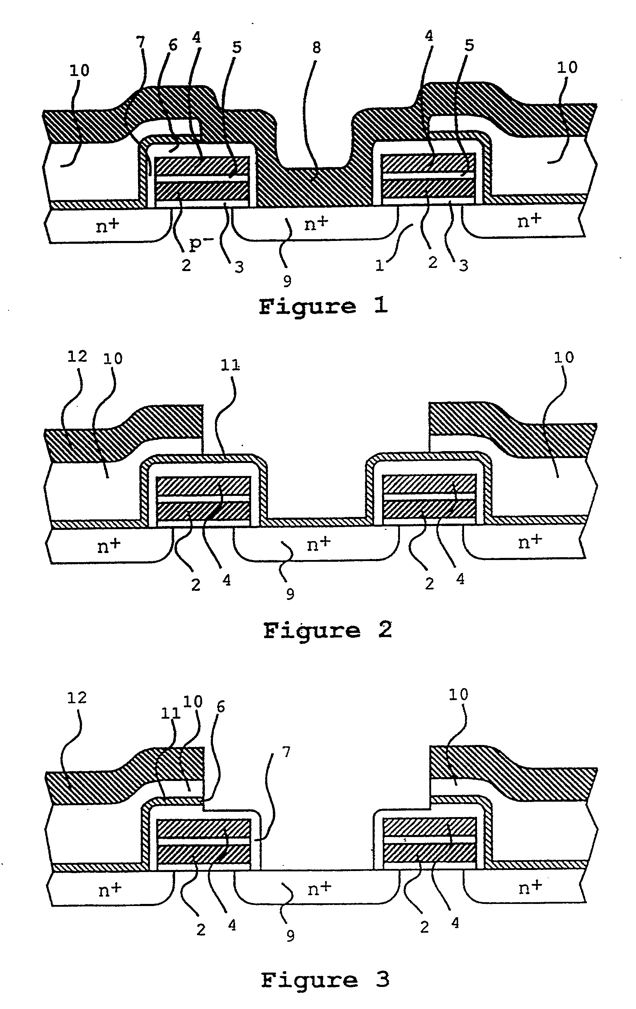

Dans la figure 1, on distingue de façon schématique les différentes couches et structures telles qu'elles apparaissent en fin de réalisation du circuit. Cette représentation est faite en coupe selon une ligne parallèle à la ligne de bit. Le substrat 1 est constitué de silicium monocristallin dopé p⁻. Les grilles flottantes 2 sont disposées au-dessus de la surface du substrat 1 et isolées de celui-ci par l'intermédiaire d'une couche mince d'oxyde de silicium 3. Les grilles de commande 4 sont disposées au-dessus des grilles flottantes 2 et isolées de celles-ci par l'intermédiaire d'une couche mince d'oxyde de silicium 5. Les grilles de commande 4 et les grilles flottantes 2 sont réalisées en silicium polycristallin. Chaque empilement des deux grilles 4 et 2 est recouvert sur sa partie supérieure 6 et sur sa partie latérale 7 d'une couche isolante d'oxyde de silicium. Les grilles sont ainsi isolées entre elles et isolées du substrat et des couches déposées par dessus. La ligne de bit 8 est constituée d'une bande de métal, généralement de l'aluminium, qui vient en contact avec des zones n⁺ 9 implantées dans le substrat et constituant les drains. Une couche isolante 10 est disposée au-dessus de zones n⁺ constituant les sources de façon que la couche métallique 8 ne vienne pas en contact avec les sources.

Après avoir réalisé les doubles grilles, les zones implantées constituant par la suite les zones de drain et de source, et après avoir recouvert les grilles 4, 2 d'une couche isolante 6, 7, selon un procédé classique, on dépose par dessus une couche de nitrure de silicium 11, comme cela est représenté en figure 2. On dépose ensuite une couche de verre BPSG 10 puis une couche de résine photosensible 12 que l'on développe de façon à ménager une zone d'ouverture au niveau du drain 9. Ensuite on effectue la gravure de la couche 10 en arrêtant l'opération de gravure lorsque la couche 11 de nitrure de silicium est atteinte.

Comme il y a une faible sélectivité, c'est-à-dire une faible différence de vitesse de gravure, entre le verre BPSG et le nitrure de silicium, il est possible que cette gravure soit trop importante et commence à enlever partiellement ou totalement la couche de nitrure de silicium 11 ainsi que la couche sous-jacente d'isolement des grilles 6, 7. On peut voir ce phénomène sur la figure 3. On comprend que, dans ce cas, l'amincissement excessif de la couche isolante 6 pourra créer par la suite un risque de claquage ou de fuite de courant électrique entre le métal 8 et la grille de commande 4.

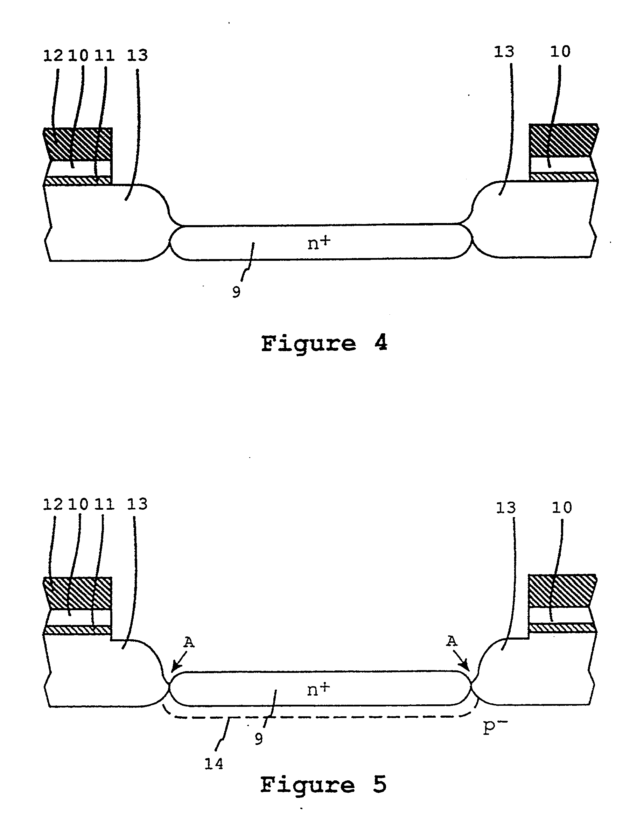

La figure 4 représente le même dispositif selon la même étape que la figure 3 mais selon une coupe perpendiculaire aux lignes de bit. On y distingue plus particulièrement des zones d'isolation latérale 13 réalisées selon le procédé classique dit LOCOS. Si l'opération de gravure du verre BPSG constituant la couche 10 est bien réalisée, c'est-à-dire sans surgravure, on peut ensuite enlever la couche de nitrure de silicium 11 mise à nue et parvenir à une structure conforme à la figure 4. Par contre, si on a effectué une surgravure, dans des conditions identiques à celles représentées en figure 3, on parvient à une structure telle que représentée en figure 5. On voit que la partie de l'oxyde épais constituant la zone d'isolation latérale 13 exposée à la gravure a été partiellement enlevée, principalement au niveau très sensible du bec d'oiseau repéré par les flèches A. Lorsque le métal viendra recouvrir cette zone A, on voit qu'il pourra être mis en contact direct avec le substrat de silicium dopé p⁻ et non avec la zone dopée n⁺, produisant ainsi des courants de fuite ou des claquages. On remédie classiquement à cet inconvénient bien connu par une opération supplémentaire, après l'opération de gravure, d'implantation n⁺ conduisant à une extension de la zone dopée référencée 14.

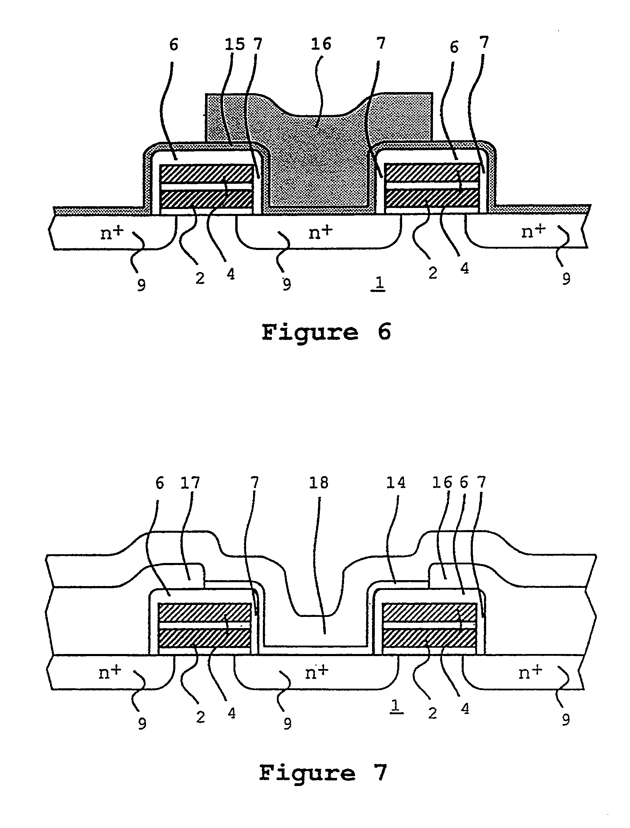

Le procédé selon l'invention va maintenant être décrit en faisant référence aux figures 6 et 7. Après avoir réalisé de façon classique les doubles grilles recouvertes d'une couche isolante 6, 7, on dépose une couche de siliciure de métal réfractaire 15, par exemple en $TiSi_2$ ou $WSi_2$. Ce siliciure de titane ou de tungstène est de préférence formé de façon à être sur-stoechiométrique en silicium pour minimiser la résistance de couche. On dépose ensuite une couche de résine photosensible que l'on développe afin de n'en laisser subsister que des îlots 16 qu'au niveau des zones de drain 9. Chaque îlot de résine 16 peut toutefois déborder latéralement au-dessus des doubles grilles 4, 2 et, dans l'autre direction perpendiculaire, au-dessus des zones d'isolation latérale 13. Ensuite, comme cela est représenté en figure 7, on effectue la gravure de la couche 15 de siliciure de métal réfractaire non recouverte de résine 16, puis on dépose une couche de verre BPSG 17 que l'on grave par une opération de photolithographie de façon à y ménager des ouvertures au niveau des drains 9, ces ouvertures pouvant déborder latéralement au-dessus des grilles 4, 2 et des zones d'isolation latérale 13. On termine le procédé de fabrication, d'une façon relativement classique, par dépôt et gravure d'une couche de métal 18, par exemple en aluminium, qui est destinée à constituer les lignes de bit.

De cette façon, l'opération de gravure de la couche de verre BPSG 17 s'effectue en débouchant sur une couche de siliciure de métal réfractaire. Or on a constaté qu'il y avait une très bonne sélectivité de gravure entre le verre BPSG et le siliciure de métal réfractaire.

Comme l'îlot de siliciure 15 déborde latéralement de la zone de drain 9, sa surface est nettement plus grande que celle de la zone de contact du drain 9 et par conséquent la couche de métal 18 est en contact avec l'îlot de siliciure 15 sur une surface relativement grande établissant ainsi un contact électrique de très faible résistance.

Les siliciures de métal réfractaire étaient déjà connus dans d'autres technologies que celles des mémoires EPROM, en particulier dans les circuits logiques de type CMOS. Dans de tels circuits, il a déjà été envisagé d'utiliser comme niveau de métal une couche de siliciure de métal réfractaire, pour ses caractéristiques particulières de faible résistivité, de bonne tenue en température et de faible diffusion d'éléments contaminants. Sa difficulté de gravure a été présentée jusque là comme un inconvénient.

Outre le fait qu'il y a une grande sélectivité entre la gravure d'un verre BPSG et d'un siliciure de métal réfractaire, il est possible de mettre au point des dispositifs simples de détection de fin d'attaque du verre (ou de commencement d'attaque de la couche de siliciure de métal réfractaire).

Le mode de réalisation qui vient d'être décrit a été présenté en relation avec diverses figures qui ne sont pas représentées à l'échelle, ni d'une figure à l'autre, ni à l'intérieur d'une figure, et notamment les épaisseurs des couches sont dessinées arbitrairement dans le but de faciliter la lecture des figures.

Dans un mode de réalisation particulier de la présente invention, il est apparu intéressant de donner à la couche de siliciure de métal réfractaire une épaisseur comprise entre 150 et 200 nanomètres, de donner à la couche de BPSG une épaisseur comprise entre 1 et 2 micromètres et de lui faire subir un traitement thermique en vue d'effectuer son fluage à une température d'environ 800°.

Les deux opérations de photolithographie correspondant respectivement à la gravure de la couche de siliciure de métal réfractaire et à la gravure du verre BPSG autorisent des variations de cote latérales relativement importantes parce qu'elles prennent place dans des zones peu sensibles, respectivement au-dessus des grilles et au-dessus des zones d'isolation latérale.

## Revendications

1. Procédé de fabrication de circuits intégrés de type MOS à transistors à grille flottante de mémoire non volatile, comprenant les étapes consistant à :
   - réaliser des zones d'isolement latéral (13),
   - réaliser entre les zones d'isolement latéral (13) des transistors MOS à double grille, les deux grilles (2, 4) étant recouvertes dessus (6) et latéralement (7) d'une couche isolante, caractérisé en ce qu'il comprend en outre les étapes suivantes :
      - déposer une couche de siliciure de métal réfractaire (15),
      - graver cette couche de siliciure (15) de façon à n'en conserver que des îlots s'étendant au niveau des contacts de drain (9) et débordant latéralement d'une part jusqu'au dessus des grilles (2,4) et d'autre part jusqu'au dessus des zones d'isolement latéral (13),
      - déposer une couche d'isolement (17) et réaliser par gravure de cette couche (17) des ouvertures débouchant au niveau des îlots de siliciure de métal réfractaire (15),
- déposer une couche de métal (18) et graver cette couche de métal (18) pour réaliser les connexions nécessaires avec les drains (9).

2. Procédé de fabrication de circuit intégré de type MOS à transistors à grille flottante selon la revendication 1, caractérisé en ce que la couche de siliciure de métal réfractaire (15) est constituée de siliciure de tantale dans lequel le silicium est légèrement sur-stoechiométrique.

3. Procédé de fabrication de circuit intégré de type MOS à transistors à grille flottante selon la revendication 1, caractérisé en ce que la couche de siliciure de métal réfractaire est constituée de siliciure de tungstène dans lequel le silicium est légèrement sur-stoechiométrique.

4. Procédé de fabrication de circuit intégré de type MOS à transistor à grille flottante selon l'une des revendications précédentes, caractérisé en ce que ladite couche d'isolement (17) déposée sur la couche de siliciure de métal réfractaire (15) est constituée de verre de silice dopé au bore et au phosphore.

Figure 1

Figure 2

Figure 3

Figure 4

Figure 5

**Figure 6**

**Figure 7**

Office européen
des brevets

# RAPPORT DE RECHERCHE EUROPEENNE

Numero de la demande

EP 90 42 0508

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 299 853 (C.E.A.)<br>* Figure 4H *<br>--- | 1 | H 01 L 21/82 |
| A | US-A-4 597 060 (TEXAS INSTRUMENTS INC.)<br>* Page 3, ligne 42 - page 4, ligne 8; figure 3 *<br>--- | 1 | |
| A | PATENT ABSTRACTS OF JAPAN, vol. 13, no. 413 (E-820)[3761], 12 septembre 1989; & JP-A-01 152 673 (TOSHIBA CORP.) 15-06-1989<br>* Abrégé; figures *<br>--- | 1 | |
| A | EXTENDED ABSTRACTS, vol. 87-1, no. 1, Spring 1987, pages 289-290, résumé no. 201, Philadelphia, PA, US; K.H. KÜSTERS et al.: "Self aligned bitline contact for 4 Mbit DRAM"<br>--- | | |
| A | EP-A-0 319 215 (AT&T)<br>--- | | DOMAINES TECHNIQUES RECHERCHES (Int. Cl.5) |
| A | US-A-4 811 078 (TEXAS INSTRUMENTS INC.)<br>* Figure 1 *<br>--- | 1 | H 01 L |
| P,A | EP-A-0 379 450 (SGS-THOMSON MICROELECTRONICS S.A.)<br>----- | | |

Le présent rapport a été établi pour toutes les revendications

| Lieu de la recherche | Date d'achèvement de la recherche | Examinateur |
|---|---|---|
| LA HAYE | 19-02-1991 | GELEBART J.F.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)